# EUROPÄISCHE PATENTSCHRIFT

(11) **EP 1 932 007 B1**
(45) Veröffentlichungstag und Bekanntmachung des Hinweises auf die Patenterteilung: **29.04.2009**
(21) Anmeldenummer: 06776945.5
(22) Anmeldetag: 18.08.2006
(51) Int. Cl.: G01R 31/28, G01D 3/08

(54) **VORRICHTUNG UND VERFAHREN ZUM FEHLERSICHEREN AUSWERTEN EINES STELLUNGSGEBERS, INSBESONDERE EINES POTENTIOMETERS**
PROCESS AND DEVICE FOR THE FAIL-SAFE EVALUATION OF A POSITION INDICATOR, IN PARTICULAR A POTENTIOMETER
DISPOSITIF ET PROCEDE D'EVALUATION A SECURITE INTEGREE D'UN TRANSMETTEUR DE POSITION, EN PARTICULIER D'UN POTENTIOMETRE

(30) Priorität: 06.10.2005 DE 102005048601
(43) Veröffentlichungstag der Anmeldung: 18.06.2008
(73) Patentinhaber: Pilz GmbH & Co. KG, 73760 Ostfildern (DE)
(72) Erfinder: PULLMANN, Juergen, 73061 Ebersbach (DE); NITSCHE, Thomas, 73732 Esslingen (DE); HORNUNG, Guenter, 70771 Leinfelden-Echterdingen (DE); ZINSER, Christoph, 72649 Wolfschlugen (DE)
(74) Vertreter: Duhme, Torsten
(86) Internationale Anmeldenummer: PCT/EP2006/008149
(87) Internationale Veröffentlichungsnummer: WO 2007/039017

(56) Entgegenhaltungen:
- EP-A- 1 022 570
- DE-A1- 19 728 596
- FR-A- 2 735 871

## Beschreibung

Die vorliegende Erfindung betrifft eine Vorrichtung zum fehlersicheren Auswerten eines Stellungsgebers, der zumindest einen ersten und einen zweiten Anschluss besitzt, zwischen denen eine definierte Gesamtimpedanz anliegt, und der einen verstellbaren Abgriff besitzt, an dem eine erste und eine zweite Teilimpedanz messbar sind, insbesondere zum fehlersicheren Auswerten eines Potentiometers, mit einer Auswerteeinheit, die mit dem Stellungsgeber verbunden ist, um eine momentane Stellposition des Abgriffs mit Hilfe von zumindest einer der Teilimpedanzen zu bestimmen, und mit einer Referenzimpedanz zum Überprüfen des Stellungsgebers.

Die Erfindung betrifft ferner ein Verfahren zum fehlersicheren Auswerten eines solchen Stellungsgebers, mit den Schritten:
- Bestimmen einer momentanen Stellposition des Abgriffs mit Hilfe von zumindest einer der Teilimpedanzen, und
- Überprüfen des Stellungsgebers mit Hilfe einer Referenzimpedanz.

Eine solche Vorrichtung und ein solches Verfahren sind aus EP 1 494 098 A1 bekannt.

Etwas allgemeiner betrifft die Erfindung eine Vorrichtung und ein Verfahren auf dem Gebiet der Sicherheitstechnik im Sinne von Schutz von Personen vor Verletzungen durch Gefahr bringende Maschinen und Anlagen. Die Absicherung solcher Maschinen und Anlagen erfolgt schon seit vielen Jahren mit Hilfe von Sicherheitsschaltvorrichtungen, die Meldesignale von Not-Aus-Tastern, Schutztürschaltern, Lichtschranken, Lichtgittern und anderen sicherheitsgerichteten Meldegeräten auswerten und in Abhängigkeit davon eine überwachte Maschine oder Anlage stromlos schalten oder anderweitig in einen gefahrlosen Zustand bringen. Typischerweise werden Sicherheitsschaltvorrichtungen in Ergänzung zu den Betriebssteuerungen der Maschine oder Anlage verwendet. Letztere steuern den "normalen" Betriebsablauf der Maschine oder Anlage. Sie sind jedoch nicht "fehlersicher" aufgebaut und können den erwünschten Schutz von Personen daher nicht gewährleisten.

Wird eine größere Anzahl von Sicherheitsfunktionen benötigt, kommen typischerweise programmierbare Sicherheitssteuerungen zum Einsatz, bei denen die Überwachung und logische Abhängigkeit der einzelnen Meldegeräte mit einer Softwareprogrammierung festgelegt werden kann. Für Anwendungen mit einer geringen oder mittleren Anzahl an Sicherheitsfunktionen werden demgegenüber meist Sicherheitsschaltgeräte eingesetzt, deren Funktion in gewissem Umfang verändert werden kann, ohne dass hierzu eine Programmierung per Software durch den Anwender erforderlich ist. Beispielsweise können bei solchen Sicherheitsschaltgeräten verschiedene Betriebsarten eingestellt werden, zum Beispiel Startbetriebsarten (automatischer Start, manueller Start, überwachter Start) oder verzögerte oder unverzögerte Abschaltung der Maschine. Im letztgenannten Fall soll der Anwender auch die Möglichkeit haben, eine Verzögerungszeit einzustellen bzw. aus einer Anzahl von vordefinierten Verzögerungszeiten auszuwählen. Darüber hinaus ist es bei manchen Sicherheitsschaltgeräten möglich, die Betriebsart an unterschiedliche Einsatzumgebungen anzupassen, beispielsweise ob das Sicherheitsschaltgerät mit getakteten oder mit nicht-getakteten Meldesignalen versorgt wird. All diese Einstellungen werden im Folgenden unter Einstellung einer Betriebsgröße zusammengefasst.

Die Einstellung von Betriebsgrößen kann beispielsweise mit Hilfe von Potentiometern oder mit Hilfe von Widerstandsnetzwerken erfolgen, die in Abhängigkeit von der Stellposition eines Bedienelements einen veränderbaren Widerstand bereitstellen. Aus Gründen der Fehlersicherheit werden bei Sicherheitsschaltgeräten jedoch zumindest zwei redundante Stellungsgeber verwendet, was auf Grund des Bauteilaufwandes und der Montagekosten nachteilig ist. In DE 100 09 707 A1 ist daher vorgeschlagen, die Schaltfunktion von zwei redundanten Drehschaltern eines Sicherheitsschaltgerätes in einem Bauelement zu vereinigen.

In DE 100 16 712 A1 ist ein Sicherheitsschaltgerät beschrieben, bei dem eine Betriebsgröße eingestellt werden kann, indem eines von zumindest drei verschiedenen Eingangssignalen an einer Eingangsklemme des Sicherheitsschaltgerätes zugeführt wird. In Abhängigkeit von dem anliegenden Eingangssignal wählt das Sicherheitsschaltgerät einen von zumindest drei vordefinierten Betriebsmodi aus. Dieses Verfahren hat sich als sehr vorteilhaft erwiesen, da die teure und aufwendige Montage von redundanten Drehschaltern oder Potentiometern entfällt. Das Verfahren setzt allerdings voraus, dass am Sicherheitsschaltgerät zumindest eine Eingangsklemme zum Zuführen des Auswahlsignals zur Verfügung steht. Dies begrenzt die minimale Baugröße eines Sicherheitsschaltgerätes.

In der eingangs genannten EP 1 494 098 A1 sind ein Verfahren und eine Vorrichtung beschrieben, um ein Potentiometer weitgehend fehlersicher auszuwerten. Dazu wird das Potentiometer in Reihe zu einem oder zwei definierten Festwiderständen geschaltet. Das Potentiometer bildet zusammen mit den beiden Festwiderständen einen Spannungsteiler und die aktuelle Stellung des Potentiometers wird an Hand des Teilerverhältnisses des Potentiometers bestimmt. Zusätzlich wird der Spannungsabfall an dem einen Festwiderstand bestimmt und mit einem Sollwert verglichen. Da das Potentiometer und der Festwiderstand vom selben Strom durchflossen sind, kann das Potentiometer anhand des Festwiderstandes überprüft werden. Nachteil dieses Verfahrens ist, dass der Spannungsbereich, der mit Hilfe des Potentiometers variiert werden kann, durch die in Reihe liegenden Festwiderstände verkleinert wird. Hierdurch wird die Anzahl der Potentiometerstellungen, die fehlersicher voneinander unterscheidbar sind, reduziert. Außerdem ist die Ermittlung der Potentiometerstellung mit Ungenauigkeiten behaftet, die von den Toleranzen der Festwiderstände abhängen. Schließlich ist diese Schaltung aufwendig, wenn mehrere Potentiometer fehlersicher ausgewertet werden sollen.

EP 1 022 570 A2, DE 43 22 472 A1 und US 5,812,411 offenbaren weitere Schaltungen, um die Stellung eines Potentiometers auszuwerten und die Funktionsfähigkeit des Potentiometers zu überprüfen. Auch diese Lösungen sind jedoch aufwendig, insbesondere wenn mehrere Potentiometer fehlersicher überwacht werden sollen. Außerdem ist auch hier die Anzahl der voneinander unterscheidbaren Potentiometerstellungen auf Grund von Toleranzen weiterer Bauteile begrenzt.

Vor diesem Hintergrund ist es eine Aufgabe der Erfindung, ein Verfahren und eine Vorrichtung der eingangs genannten Art anzugeben, die eine genaue und fehlersichere Auswertung eines impedanzbasierten Stellungsgebers mit einer geringen Anzahl an Bauelementen ermöglichen. Es ist insbesondere eine Aufgabe der Erfindung, ein Verfahren und eine Vorrichtung anzugeben, die mit wenigen Bauelementen und geringem Platzbedarf eine fehlersichere Betriebsgrößeneinstellung bei einer Sicherheitsschaltvorrichtung (Sicherheitsschaltgerät oder Sicherheitssteüerung) ermöglichen.

Gemäß einem Aspekt der Erfindung wird diese Aufgabe durch eine Vorrichtung der eingangs genannten Art gelöst, bei der die Auswerteeinheit dazu ausgebildet ist, eine für die erste Teilimpedanz repräsentative erste Messgröße und eine für die zweite Teilimpedanz repräsentative zweite Messgröße zu bestimmen.

Gemäß einem weiteren Aspekt der Erfindung wird diese Aufgabe durch ein Verfahren der eingangs genannten Art gelöst, bei dem eine für die erste Teilimpedanz repräsentative erste Messgröße bestimmt wird und bei dem eine für die zweite Teilimpedanz repräsentative zweite Messgröße bestimmt wird, wobei die Stellposition des Abgriffs anhand der ersten und der zweiten Messgröße überprüft wird.

Wie schon weiter oben erwähnt ist, lassen sich die neue Vorrichtung und das neue Verfahren nicht nur zum Überwachen und Auswerten eines Potentiometers verwenden, sondern auch zum Überwachen und Auswerten jedes anderen impedanzbasierten Stellungsgebers. Anstelle eines Potentiometers könnte es sich beispielsweise um ein Widerstandsnetzwerk mit auswählbaren Widerständen handeln. Außerdem kann die Gesamtimpedanz des Stellungsgebers kapazitive und induktive Anteile enthalten, d.h. die Erfindung ist nicht auf Ohmsche Stellungsgeber begrenzt.

Die Erfindung basiert auf der Idee, jede der variablen Teilimpedanzen, die sich zu der Gesamtimpedanz addieren, messtechnisch zu bestimmen. Dabei ist es nicht erforderlich, tatsächlich eine Impedanzmessung im engeren Sinne vorzunehmen. Es genügt, wenn repräsentative (jedoch separate) Messgrößen für die einzelnen Teilimpedanzen bestimmt werden. Bevorzugt ist die Messung eines Spannungsabfalls an jeder der Teilimpedanzen.

Im Gegensatz dazu wird bei allen bislang bekannten Vorgehensweisen zum Auswerten und Überwachen eines impedanzbasierten Stellungsgebers nur ein Teilerverhältnis der Teilimpedanzen messtechnisch erfasst. Bei bekannter Gesamtimpedanz kann man dann zwar die Teilimpedanzen ermitteln, sie werden jedoch nicht separat voneinander messtechnisch erfasst. Die neue Vorgehensweise ermöglicht es, die unabhängig voneinander bestimmten Teilimpedanzen miteinander und/oder mit der bekannten oder gemessenen Gesamtimpedanz zu vergleichen. Dies ermöglicht eine Vielzahl von Plausibilitätsprüfungen, die schaltungstechnisch sehr einfach zu realisieren sind, sowie eine sehr einfache, redundante Auswertung. In einem besonders bevorzugten Ausführungsbeispiel benötigt die neue Vorrichtung beispielsweise nur einen Festwiderstand in Ergänzung zu zwei Mikrocontrollern. Zwei Mikrocontroller werden bei Sicherheitsschaltvorrichtungen aus Gründen der Redundanz ohnehin häufig eingesetzt, so dass der Bauteilaufwand hier äußerst gering ist.

Insgesamt ermöglichen die neue Vorrichtung und das neue Verfahren eine genaue und fehlersichere Auswertung eines impedanzbasierten Stellungsgebers mit einer geringen Anzahl an Bauelementen. Dies wiederum eröffnet die Möglichkeit, eine fehlersichere Betriebsgrößeneinstellung zu realisieren, ohne dass Anschlussklemmen und/oder redundante Stellungsgeber benötigt werden. Die neue Vorrichtung und das neue Verfahren ermöglichen daher eine sehr kleinbauende und kostengünstige Realisierung eines Sicherheitsschaltgerätes oder einer Sicherheitssteuerung mit einer fehlersicheren Betriebsgrößeneinstellung.

Die oben genannten Aufgaben sind daher vollständig gelöst.

In einer bevorzugten Ausgestaltung beinhaltet die Auswerteeinheit einen ersten Auswerteschaltkreis und einen zweiten Auswerteschaltkreis, von denen jeder dazu ausgebildet ist, zumindest eine der Messgrößen zu bestimmen. Bevorzugt kann jeder Auswerteschaltkreis jede Messgröße messtechnisch erfassen.

In dieser Ausgestaltung kann jeder der Auswerteschaltkreise die Teilimpedanzen des Stellungsgebers messtechnisch zu erfassen. Daher kann jeder Auswerteschaltkreis die Stellposition des Stellungsgebers bestimmen. Eine solche Realisierung ist für Sicherheitsschaltvorrichtungen besonders gut geeignet.

In einer weiteren Ausgestaltung weisen der erste Auswerteschaltkreis einen ersten Ausgang und der zweite Auswerteschaltkreis einen zweiten Ausgang auf, die jeweils wechselweise mit einem hohen Potential oder einem niedrigen Potential belegt werden können.

Diese Ausgestaltung ermöglicht es, den Stellungsgeber wechselweise mit Spannungen unterschiedlicher Polarität zu versorgen. Die Teilimpedanzen lassen sich dann messtechnisch sehr einfach erfassen.

In einer weiteren Ausgestaltung ist der erste Ausgang mit dem ersten Anschluss des Stellungsgebers verbunden und der zweite Ausgang ist mit dem zweiten Anschluss des Stellungsgebers verbunden.

In dieser Ausgestaltung liegt der Stellungsgeber gewissermaßen zwischen den Ausgängen der Auswerteschaltkreise, die wechselweise mit einem hohen oder einem niedrigen Potential belegt werden können. Auf diese Weise kann die am Stellungsgeber anliegende Spannung einfach umgekehrt werden, was eine besonders einfache Bestimmung der Teilimpedanzen ermöglicht. Dabei versteht es sich, dass der Stellungsgeber mit den beiden Auswerteschaltkreisen auch mittelbar verbunden sein kann, d.h. über dazwischenliegende Widerstände oder andere Bauelemente. Bevorzugt ist es jedoch, wenn der Stellungsgeber direkt zwischen die Ausgänge der Auswerteschaltkreise geschaltet ist, um den maximalen Spannungsbereich für die Auswertung zur Verfügung zu stellen.

In einer weiteren Ausgestaltung sind der erste und der zweite Ausgang mit dem Abgriff verbunden.

In dieser Ausgestaltung wird die wechselnde Spannung an dem Abgriff des Stellungsgebers eingespeist. Dies ermöglicht es, die erste und zweite Messgröße simultan zu erfassen. Die Auswertung und Überprüfung kann daher sehr schnell erfolgen.

In einer weiteren Ausgestaltung ist zumindest ein Schaltelement vorgesehen, das dazu ausgebildet ist, den Stellungsgeber von dem ersten oder zweiten Ausgang zu trennen.

Mit anderen Worten beinhaltet diese Ausgestaltung die Möglichkeit, die Verbindung zwischen dem Stellungsgeber und den Ausgängen der Auswerteschaltkreise hochohmig zu machen. Dies kann vorteilhafterweise auch am Ausgang des Auswerteschaltkreises selbst geschehen. Diese Ausgestaltung ist eine sehr einfache Möglichkeit, um die Teilimpedanzen durch eine Spannungsumkehr messtechnisch zu erfassen.

In einer weiteren Ausgestaltung weisen der erste Auswerteschaltkreis einen ersten Eingang und der zweite Auswerteschaltkreis einen zweiten Eingang auf, die jeweils mit dem Stellungsgeber verbunden sind.

In dieser Ausgestaltung ist der Stellungsgeber also auch zwischen die Eingänge der Auswerteschaltkreise geschaltet. Jeder Auswerteschaltkreis kann daher eine für die Teilimpedanzen repräsentative Messgröße direkt einlesen. Dies ermöglicht eine schnelle Auswertung der Stellposition mit einer hohen Fehlersicherheit.

In einer weiteren Ausgestaltung sind der erste und der zweite Eingang mit dem Abgriff verbunden.

Diese Ausgestaltung erlaubt es, die erste und die zweite Messgröße jeweils redundant aufzunehmen. Jeder Auswerteschaltkreis kann jede der beiden Messgrößen erfassen und die zugehörige Teilimpedanz bestimmen. Daher kann jede Teilimpedanz redundant überwacht werden, was eine besonders hohe Fehlersicherheit ermöglicht.

Besonders bevorzugt ist es, wenn in diesem Fall auch die Referenzimpedanz einen ersten Anschluss aufweist, der mit dem Abgriff verbunden ist.

Mit dieser Ausgestaltung können Driftfehler des Stellungsgebers und vor allem Driftfehler der Teilimpedanzen sehr einfach und zuverlässig erkannt werden.

In einer weiteren Ausgestaltung ist der erste Eingang mit dem ersten Anschluss des Stellungsgebers und der zweite Eingang mit dem zweiten Anschluss des Stellungsgebers verbunden.

In dieser Ausgestaltung erfasst jeder Auswerteschaltkreis "seine" Teilimpedanz. Hierdurch ist eine sehr schnelle Auswertung des Stellungsgebers möglich.

In einer weiteren Ausgestaltung weist die Referenzimpedanz einen zweiten Anschluss auf, der mit einem Ausgang der Auswerteeinheit verbunden ist. Besonders bevorzugt ist es, wenn außerdem ein Schaltelement vorgesehen ist, um die Verbindung zwischen der Referenzimpedanz und dem Ausgang wahlweise hochohmig zu schalten.

Diese Ausgestaltung ermöglicht es, die Referenzimpedanz für den Messbetrieb "unsichtbar" zu machen, so dass die für die Teilimpedanzen repräsentativen Messgrößen unabhängig von der Referenzimpedanz und deren Toleranzen sind. Dies ermöglicht eine genauere und feiner aufgelöste Auswertung des Stellungsgebers.

In einer weiteren Ausgestaltung ist eine Vielzahl von Stellungsgebern mit einer Vielzahl von Abgriffen vorgesehen, die miteinander verbunden sind, wobei jeder Stellungsgeber einen ersten und einen zweiten Anschluss aufweist, der mit der Auswerteeinheit verbunden ist.

Diese Ausgestaltung ist eine sehr einfache und bauteilsparende Möglichkeit, um mehrere Stellungsgeber in der erfindungsgemäßen Weise auszuwerten und zu überwachen. Sie ermöglicht die Einstellung einer Vielzahl von Betriebsgrößen mit einem sehr geringen Bauteilaufwand und Platzbedarf.

In einer weiteren Ausgestaltung sind der erste und der zweite Auswerteschaltkreis integrierte Schaltkreise, insbesondere programmierbare integrierte Schaltkreise, die über den Stellungsgeber miteinander verbunden sind. In besonders bevorzugten Ausgestaltungen sind die integrierten Schaltkreise über den Stellungsgeber direkt miteinander verbunden. Mit anderen Worten ist der Stellungsgeber dann direkt zwischen die integrierten Schaltkreise geschaltet.

Die Verwendung von integrierten Schaltkreisen ist für sich genommen auch auf dem Gebiet der Sicherheitstechnik bekannt. Besonders vorteilhaft ist es jedoch, den ersten und zweiten Auswerteschaltkreis mit Hilfe eines Mikrocontrollers, Mikroprozessors, FPGAs oder anderer integrierter Logikschaltkreise zu realisieren. Die Anzahl der benötigten Bauelemente wird dadurch auf ein Minimum reduziert. Entsprechend gering sind die Fertigungskosten und der benötigte Bauraum.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte, schematische Darstellung einer Sicherheitsschaltvorrichtung zum fehlersicheren Abschalten eines elektrischen Verbrauchers gemäß einem bevorzugten Ausführungsbeispiel der Erfindung,
- Fig. 2: eine vereinfachte Darstellung eines ersten Ausführungsbeispiels der neuen Vorrichtung zum fehlersicheren Auswerten eines Stellungsgebers,
- Fig. 3 und Fig. 4: die Vorrichtung aus Fig. 2 in zwei verschiedenen Betriebszuständen,
- Fig. 5: ein zweites Ausführungsbeispiel der neuen Vorrichtung,
- Fig. 6: ein drittes Ausführungsbeispiel der neuen Vorrichtung,
- Fig. 7: ein viertes Ausführungsbeispiel der neuen Vorrichtung, und
- Fig. 8: ein fünftes Ausführungsbeispiel der neuen Vorrichtung.

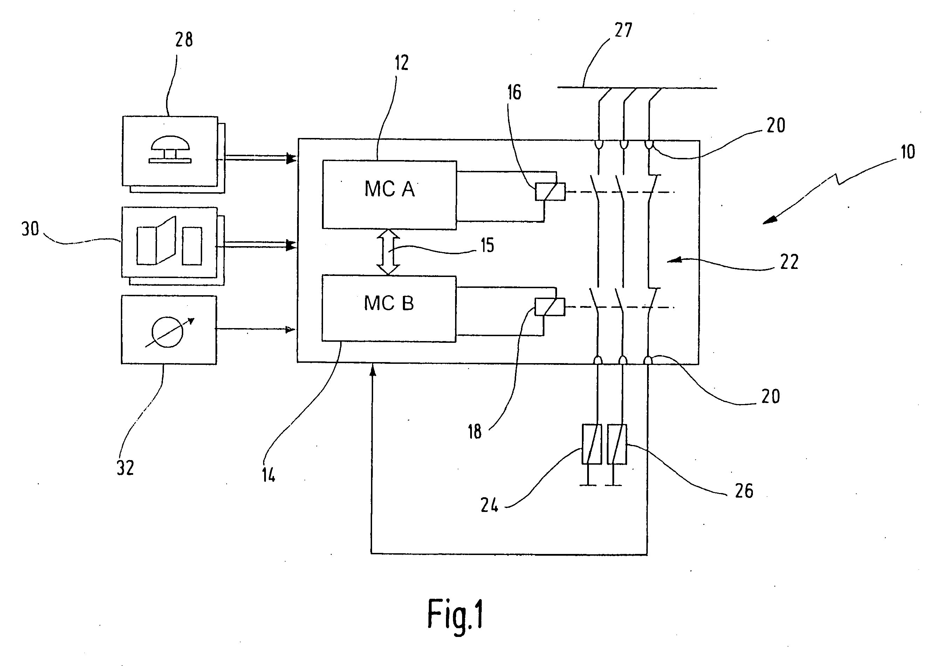

In Fig. 1 ist ein Sicherheitsschaltgerät, bei dem das neue Verfahren und die neue Vorrichtung zur Anwendung kommen, in seiner Gesamtheit mit der Bezugsziffer 10 bezeichnet. Das Sicherheitsschaltgerät 10 ist zweikanalig aufgebaut und besitzt zwei Mikrocontroller 12, 14, die über eine Verbindung 15 miteinander kommunizieren können, um ihre Daten zu vergleichen und sich gegenseitig zu überwachen. Die Verbindung 14 kann beispielsweise ein Dual-Ported-RAM oder eine Kommunikationschnittstelle (zum Beispiel UART) sein.

Jeder der Mikrocontroller 12, 14 steuert ein Relais 16, 18 an. Die Schaltkontakte der Relais 16, 18 liegen in Reihe zueinander zwischen Anschlussklemmen 20 des Sicherheitsschaltgerätes 10. Sie bilden damit Strompfade 22 zwischen den Anschlussklemmen 20, die mit Hilfe der Mikrocontroller 12, 14 fehlersicher geöffnet werden können. Die Schließerkontakte der Relais 16, 18 bilden zwei Strompfade 22, über die zwei Schütze 24, 26 mit einer externen Stromversorgung 27 verbunden sind. Die Schütze 24, 26. sind elektrische Verbraucher im Sinne der vorliegenden Erfindung und sie dienen beispielsweise dazu, den Antrieb einer hier nicht dargestellten Maschine fehlersicher abzuschalten. Die Öffnerkontakte der Relais 16, 18 sind mit den Schließkontakten zwangsgeführt, und sie bilden einen Rückführkreis, über den die Mikrocontroller 12, 14 den Schaltzustand der Relais 16, 18 einlesen können.

Die Verwendung von Relais 16, 18 als ausgangsseitige Schaltelemente des Sicherheitsschaltgerätes 10 ist beispielhaft zu verstehen. Die Erfindung kann auch bei Sicherheitsschaltgeräten mit Halbleiterausgängen und darüber hinaus auch bei anderen Geräten und Vorrichtungen eingesetzt werden, bei denen ein impedanzbasierter Stellungsgeber fehlersicher ausgewertet und überwacht werden soll.

Eingangsseitig nimmt das Sicherheitsschaltgerät 10 die Meldesignale eines oder mehrerer Not-Aus-Taster 28 und eines oder mehrerer Schutztürschalter 30 auf. Darüber hinaus könnte das Sicherheitsschaltgerät 10 auch zum Anschluss von anderen Meldegeräten ausgebildet sein, beispielsweise Lichtschranken, Lichtgittern, Drehzahlgebern u.a.

Mit der Bezugsziffer 32 ist ein schematisch dargestellter Stellungsgeber bezeichnet, der in dem Sicherheitsschaltgerät 10 nach dem neuen.Verfahren ausgewertet und überwacht wird. Die Darstellung des Stellungsgebers 32 als "externem" Gerät ist der Einfachheit halber gewählt. Typischerweise wird der Stellungsgeber 32 innerhalb des Gerätegehäuses des Sicherheitsschaltgerätes 10 angeordnet sein, wobei ein Bedienknopf, zum Beispiel ein Drehsteller, an einer Gehäuseseite des Sicherheitsschaltgerätes 10 zugänglich ist.

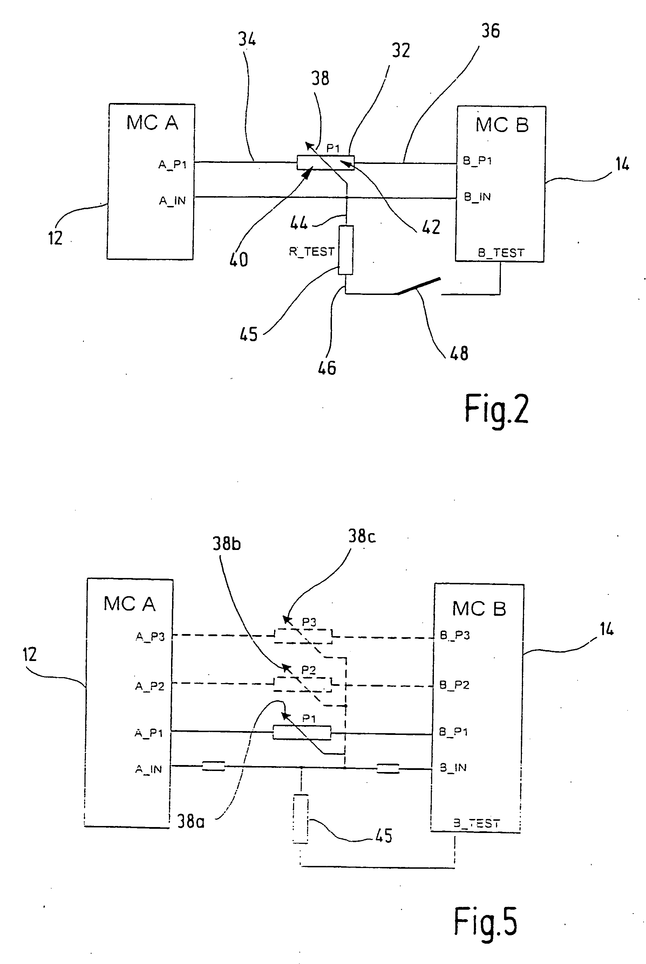

Fig. 2 zeigt ein bevorzugtes Ausführungsbeispiel zum Auswerten und Überwachen des Stellungsgebers 32. In dem besonders bevorzugten Ausführungsbeispiel handelt es sich um ein Potentiometer mit einem ersten Anschluss 34, einem zweiten Anschluss 36 sowie einem verstellbaren Abgriff 38. Zwischen den Anschlüssen 34, 36 besitzt das Potentiometer eine definierte Gesamtimpedanz. Am verstellbaren Abgriff 38 sind eine erste und eine zweite Teilimpedanz 40, 42 messbar, deren Summe der Gesamtimpedanz entspricht.

Die vorliegende Erfindung ist jedoch nicht auf die Auswertung von Potentiometern beschränkt. Sie kann auch bei Widerstandsnetzwerken und anderen Bauelementen oder Schaltungsbestandteilen angewendet werden, bei denen eine Gesamtimpedanz über einen verstellbaren Abgriff in zwei (oder mehr) Teilimpedanzen unterteilt wird und die Teilimpedanzen bestimmt werden.

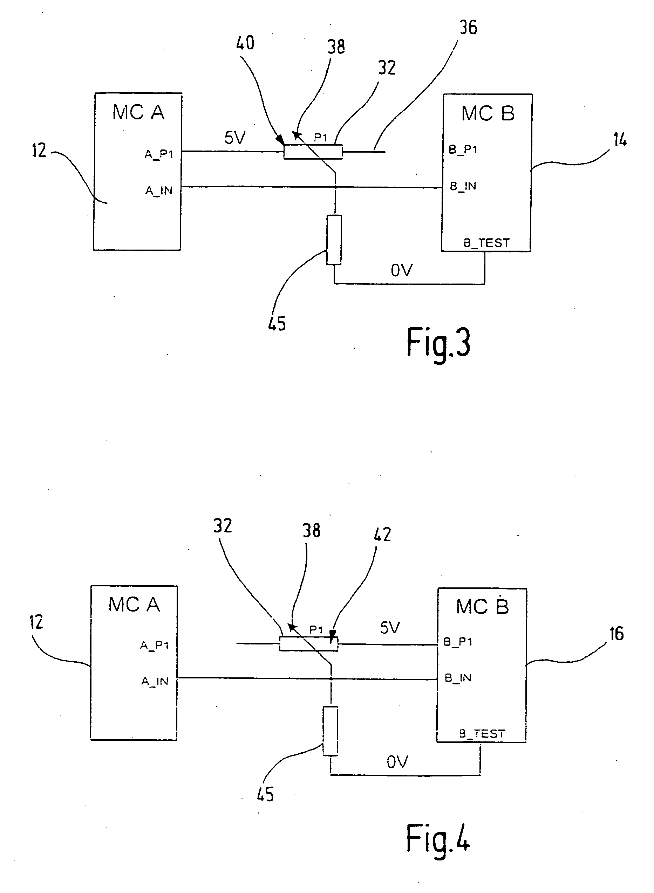

Der erste Anschluss 34 des Potentiometers 32 ist mit einem Portanschluss A P1 des Mikrocontrollers 12 verbunden. In gleicher Weise ist der zweite Anschluss 36 des Potentiometers 32 mit einem Portanschluss B_P1 des Mikrocontrollers 14 verbunden. Die Portanschlüsse A_P1, B_P1 der Mikrocontroller 12, 14 können von den Mikrocontrollern wahlweise mit einem hohen Spannungspotential (beispielsweise Betriebsspannung) oder einem niedrigen Spannungspotential (beispielsweise Masse) belegt werden. Außerdem können die beiden Porteingänge von den Mikrocontrollern hochohmig geschaltet werden, was einer Auftrennung der Verbindung zwischen dem ersten bzw. zweiten Anschluss 34, 36 und dem zugehörigen .Mikrocontroller 12, 14 entspricht (dargestellt in Fig. 3 und 4).

Der Abgriff 38 des Potentiometers 32 ist sowohl mit einem Eingang A_IN am Mikrocontroller 12 als auch mit einem Eingang B_IN am Mikrocontroller 14 verbunden. Die Eingänge A_IN, B_IN ermöglichen es den Mikrocontrollern, eine am Abgriff 38 des Potentiometers 32 anliegende Spannung aufzunehmen. In einem besonders bevorzugten Ausführungsbeispiel beinhaltet jeder Mikrocontroller 12, 14 einen integrierten A/D-Wandler, der die an den Eingängen A_IN, B_IN anliegenden Spannungen in einen Digitalwert umwandelt, der anschließend vom Mikrocontroller weiter verarbeitet werden kann. Die an den Eingängen A_IN, B_IN anliegenden Spannungen sind die Messgrößen, die für die Teilimpedanzen 40, 42 des Potentiometers 3 repräsentativ sind 2.

Darüber hinaus ist der Abgriff 38 auch noch mit einem ersten Anschluss 44 eines Festwiderstandes 45 verbunden, der hier als Referenzimpedanz dient. Der zweite Anschluss 46 des Festwiderstandes 45 ist über ein Schaltelement 48 mit einem Portanschluss B_TEST des Mikrocontrollers 14 verbunden. Der Abgriff 38 des Potentiometers 32 liegt also in Reihe zu dem Festwiderstand 45 und die Reihenschaltung ist über das Schaltelement 48 an den Portanschluss B_TEST des Mikrocontrollers 14 geführt. Alternativ oder ergänzend könnte die Reihenschaltung auch mit einem entsprechenden Portanschluss A_TEST (nicht dargestellt) am Mikrocontroller 12 verbunden sein.

Der Mikrocontroller 14 ist in der Lage, am Portanschluss B_TEST ein Massepotential anzulegen. Darüber hinaus kann die Verbindung zwischen dem Festwiderstand 45 und dem Mikrocontroller 14 über das Schaltelement 48 hochohmig geschaltet werden. Das Schaltelement 48 ist hier zur bildlichen Darstellung gezeigt. In bevorzugten Ausführungsbeispielen ist der Mikrocontroller 14 in der Lage, den Portanschluss B_TEST über ein integriertes Schaltelement (nicht dargestellt) hochohmig zu schalten.

Die Funktionsweise dieser neuen Vorrichtung zum Überprüfen des Potentiometers 32 ist in den Fig. 3 und 4 dargestellt, wobei gleiche Bezugszeichen jeweils dieselben Elemente bezeichnen wie zuvor.

Zum Testen des Potentiometers 32 legt der Mikrocontroller 12 ein hohes Spannungspotential von beispielsweise 5 Volt an den Portanschluss A_P1. Der Mikrocontroller 14 schaltet seinen Portanschluss B_P1 hochohmig, was in Fig. 3 bildlich dargestellt ist, indem die Verbindung zwischen dem Anschluss 36 und dem Portanschluss B_P1 aufgetrennt ist. Außerdem legt der Mikrocontroller 14 ein niedriges Spannungspotential, vorzugsweise Masse, an den Portanschluss B_TEST. In diesem Fall bildet die erste Teilimpedanz 40 des Potentiometers 32 einen Spannungsteiler mit dem Festwiderstand 45. Die an der Teilimpedanz 40 abfallende Teilspannung kann an den Eingängen A_IN, B_IN gemessenen werden. Dieser Spannungsabfall an der Teilimpedanz 40 ist ein Maß für die Größe der Teilimpedanz 40.

Anschließend wird gemäß Fig. 4 die zweite Teilimpedanz 42 des Potentiometers 32 bestimmt, indem der Mikrocontroller 14 an seinem Portanschluss B_P1 ein hohes Spannungspotential, beispielsweise 5 Volt, anlegt, während der Mikrocontroller 12 seinen Portanschluss A_P1 hochohmig schaltet. Nun wird der Spannungsteiler aus der zweiten Teilimpedanz 42 und dem Festwiderstand 45 gebildet. Die an der Teilimpedanz 42 abfallende Spannung kann an den Eingängen A_IN, B_IN gemessen werden. Eine Addition der messtechnisch bestimmten Teilspannungen/- impedanzen ermöglicht es, etwaige Kontaktfehler und auch Driftfehler des Potentiometers 32 zu detektieren. Außerdem kann aus der Kenntnis der beiden Teilimpedanzen 40, 42 die Stellposition des Potentiometers 32 bestimmt werden, was eine Plausibilitätsprüfung ermöglicht, da die Stellposition des Potentiometers 32 in nachfolgend beschriebener Weise auch noch messtechnisch erfasst werden kann. Schließlich können mit diesem Testszenario auch Stuck-at-Fehler an den genannten Portanschlüssen der Mikrocontroller 12, 14 erkannt werden.

Die Stellposition des Potentiometers 32 kann bei der Vorrichtung aus Fig. 2 messtechnisch bestimmt werden, indem der Portanschluss B_TEST hochohmig geschaltet wird (Schaltelement 48 geöffnet), am Portanschluss A_P1 des Mikrocontrollers 12 ein hohes Spannungspotential, beispielsweise 5 Volt, und am Portanschluss B_P1 des Mikrocontrollers 14 ein niedriges Spannungspotential, beispielsweise Masse, angelegt wird. Die Spannungspotentiale an den Portanschlüssen A_P1, B_P1 könnten auch vertauscht sein. In beiden Fällen liegt eine Spannung quert über dem Potentiometer 32, wobei der Abgriff 38 einen Spannungsteiler bildet. Das Einlesen der am Abgriff 38 anliegenden Teilspannung ermöglicht die messtechnische Bestimmung der Stellposition des Potentiometers 32.

Wie die einschlägigen Fachleute leicht nachvollziehen können, kann die vorliegende Schaltung zum fehlersicheren Auswerten des Potentiometers 32 auch mit unterschiedlichen Versorgungsspannungen an den Mikrocontrollern 12, 14 betrieben werden. Dies ermöglicht eine besonders hohe Fehlersicherheit auf Grund der diversitären Redundanz. Darüber hinaus besitzt dieses Ausführungsbeispiel den Vorteil, dass die Stellposition des Potentiometers 32 unabhängig vom jeweiligen Impedanzwert des Potentiometers und unabhängig von den Werten und Toleranzen des Festwiderstandes 45, des Schleiferübergangswiderstandes des Potentiometers und unabhängig von der Versorgungsspannung ist. Außerdem ändert sich die am Abgriff 38 anliegende Teilspannung linear mit der Änderung der Stellposition, so dass eine Vielzahl von Stellpositionen mit gleichbleibender Genauigkeit über den gesamten Arbeitsbereich des Potentiometers 32 hinweg identifiziert werden können.

Die hier erläuterte Realisierung mit zwei Mikrocontrollern ist bei Sicherheitsschaltvorrichtungen bevorzugt, die bereits zur Auswertung und .Überwachung der Meldegeräte redundante Mikrocontroller verwenden. Der zusätzliche Bauteilaufwand ist minimal. Grundsätzlich kann die Erfindung jedoch auch mit nur einem Mikrocontroller (oder einer anderen "einkanaligen" Auswerteeinheit) realisiert werden, indem die erste und zweite Messgröße zeitlich nacheinander und/oder über verschiedene Porteingänge der einen Auswerteeinheit gemessen werden.

Fig. 5 zeigt ein weiteres Ausführungsbeispiel, in dem gleiche Bezugszeichen dieselben Elemente bezeichnen wie zuvor. In diesem Fall sind drei Potentiometer P1, P2, P3 mit ihren ersten und zweiten Anschlüssen zwischen entsprechende Portanschlüsse der Mikrocontroller 12, 14 geschaltet Die Abgriffe 38a, 38b, 38c der drei Potentiometer sind in einem Knoten zusammengeführt und in der zuvor beschriebenen Weise sowohl mit den Eingängen A_IN, B_IN der beiden Mikrocontroller 12, 14 als auch über den Festwiderstand 45 mit dem Portanschluss B_TEST verbunden. Mit einer solchen Anordnung können mehrere Potentiometer P1, P2, P3 in der zuvor beschriebenen Weise ausgewertet und überwacht werden. Gemäß einem alternativen Ausführungsbeispiel sind in Fig. 5 noch zwei Widerstände in den Verbindungsleitungen zwischen den Abgriffen 38a, 38b, 38c und den Eingängen A_IN, B_IN der Mikrocontroller 12, 14 dargestellt. Diese Widerstände dienen hier zur Entkopplung, können jedoch in anderen Ausführungsbeispielen entfallen.

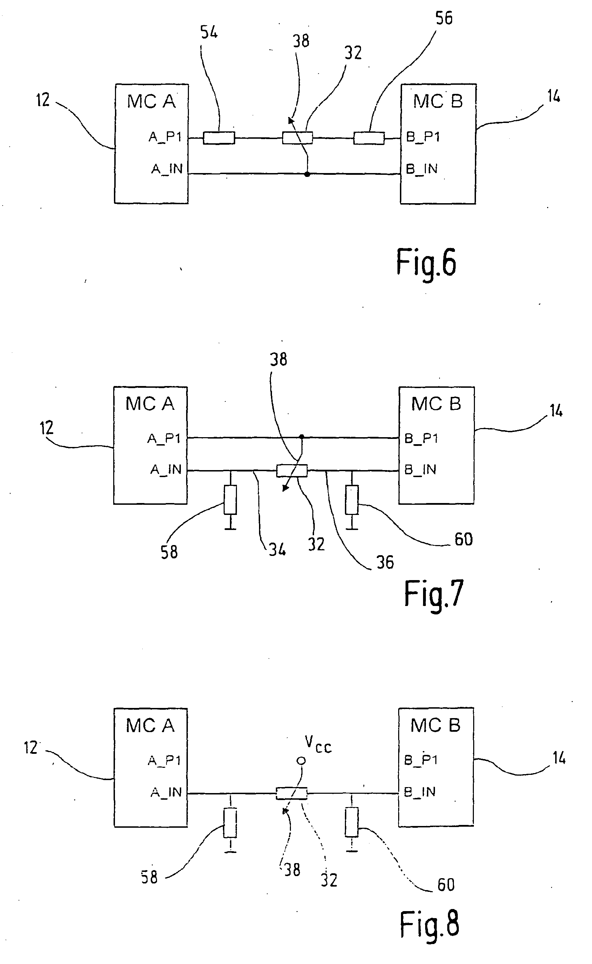

Fig. 6 zeigt ein weiteres Ausführungsbeispiel einer Vorrichtung zum fehlersicheren Auswerten eines Stellungsgebers, wiederum am Beispiel eines Potentiometers 32. Im Übrigen bezeichnen gleiche Bezugszeichen dieselben Elemente wie zuvor. In dem Ausführungsbeispiel gemäß Fig. 6 liegt das Potentiometer 32 mit seinen Anschlüssen 34, 36 zwischen den Portanschlüssen A_P1, B_P1 der Mikrocontroller 12, 14. Der Abgriff 38 ist parallel mit den beiden Eingängen A_IN, B_IN der Mikrocontroller 12, 14 verbunden. Im Unterschied zum vorhergehenden Ausführungsbeispiel werden zwei Festwiderstände 54, 56 verwendet, wobei der Widerstand 54 zwischen dem ersten Anschluss 34 des Potentiometers 32 und dem Portanschluss A_P1 des Mikrocontrollers 12 liegt, während der zweite Widerstand 56 zwischen dem zweiten Anschluss 36 des Potentiometers 32 und dem Portanschluss B_P1 des Mikrocontrollers 14 liegt. Mit Hilfe der Widerstände 54, 56 lässt sich bei unterschiedlichen Versorgungsspannungen der Mikrocontroller 12, 14 vermeiden, dass an den Mikrocontroller mit der niedrigeren Versorgungsspannung ein Spannungspotential gelangt, das seine Versorgungsspannung übersteigt. Vorzugsweise sind die beiden Widerstände 54, 56 gleich groß, so dass die Spannung am Abgriff 38 genau der Hälfte der über der Reihenschaltung 32, 54, 56 anliegenden Spannung ist, wenn sich das Potentiometer 32 in Mittelstellung befindet. Durch wechselseitiges Umschalten der Potentiale an den Portausgängen A_P1, B_P1 können die Teilimpedanzen des Potentiometers 32 bestimmt werden, und es ist ein Plausibilitätstest zur Funktionsüberprüfung des Potentiometers 32 möglich.

Fig. 7 zeigt ein Ausführungsbeispiel, bei dem das Potentiometer 32 mit seinen Anschlüssen 34, 36 zwischen den Eingängen A_IN, B_IN der Mikrocontroller 12, 14 liegt. Der Abgriff 38 ist parallel mit den Portanschlüssen A_P1, B_P1 verbunden. Außerdem liegt der Anschluss 34 über einen Widerstand 58 an Masse, der Anschluss 36 liegt über einen Widerstand 60 an Masse. In diesem Fall kann ein wechselndes Spannungspotential am Abgriff 38 eingespeist werden, indem jeweils ein Mikrocontroller 12, 14 seinen Portanschluss hochohmig schaltet, während der andere ein hohes Potential ausgibt.

Das Ausführungsbeispiel in Fig. 8 entspricht dem Ausführungsbeispiel in Fig. 7, allerdings mit der Ausnahme, dass am Abgriff 38 ein festes Potential V_{cc} anliegt. In den beiden zuletzt genannten Ausführungsbeispielen messen die Mikrokontroller jeweils entgegengesetzte Teilspannungen am Potentiometer 32, die den jeweiligen Teilimpedanzen entsprechen.

## Patentansprüche

1. Vorrichtung zum fehlersicheren Auswerten eines Stellungsgebers (32), der zumindest einen ersten und einen zweiten Anschluss (34, 36) besitzt, zwischen denen eine definierte Gesamtimpedanz anliegt, und der einen verstellbaren Abgriff (38) besitzt, an dem eine erste und eine zweite Teilimpedanz (40, 42) messbar sind, insbesondere zum fehlersicheren Auswerten eines Potentiometers, mit einer Auswerteeinheit (12, 14), die mit dem Stellungsgeber (32) verbunden ist, um eine momentane Stellposition des Abgriffs (38) mit Hilfe von zumindest einer der Teilimpedanzen (40, 42) zu bestimmen, und mit einer Referenzimpedanz (45; 54, 56; 58, 60) zum Überprüfen des Stellungsgebers (32), **dadurch gekennzeichnet, dass** die Auswerteeinheit (12, 14) dazu ausgebildet ist, eine für die erste Teilimpedanz (40) repräsentative erste Messgröße und eine für die zweite Teilimpedanz (42) repräsentative zweite Messgröße zu bestimmen.

2. Vorrichtung nach Anspruch 1, **dadurch gekennzeichnet, dass** die Auswerteeinheit (12, 14) einen ersten Auswerteschaltkreis (12) und einen zweiten Auswerteschaltkreis (14) beinhaltet, von denen jeder dazu ausgebildet ist, zumindest eine der Messgrößen zu bestimmen.

3. Vorrichtung nach Anspruch 2, **dadurch gekennzeichnet, dass** der erste Auswerteschaltkreis (12) einen ersten Ausgang (A_P1) und der zweite Auswerteschaltkreis (14) einen zweiten Ausgang (B_P1) aufweisen, die jeweils wechselweise mit einem hohen Potential oder einem niedrigen Potential belegt werden können.

4. Vorrichtung nach Anspruch 3, **dadurch gekennzeichnet, dass** der erste Ausgang (A_P1) mit dem ersten Anschluss (34) des Stellungsgebers (32) verbunden ist und dass der zweite Ausgang (B_P1) mit dem zweiten Anschluss (36) des Stellungsgebers (32) verbunden ist.

5. Vorrichtung nach Anspruch 3, **dadurch gekennzeichnet, dass** der erste und der zweite Ausgang (A_P1, B_P1) mit dem Abgriff (38) verbunden sind.

6. Vorrichtung nach einem der Ansprüche 3 bis 5, **gekennzeichnet durch** zumindest ein Schaltelement, das dazu ausgebildet ist, den Stellungsgeber (32) von dem ersten oder zweiten Ausgang (A_P1, B_P1) zu trennen.

7. Vorrichtung nach einem der Ansprüche 2 bis 6, **dadurch gekennzeichnet, dass** der erste Auswerteschaltkreis (12) einen ersten Eingang (A_IN) und der zweite Auswerteschaltkreis (14) einen zweiten Eingang (B_IN) aufweisen, die jeweils mit dem Stellungsgeber (32) verbunden sind.

8. Vorrichtung nach Anspruch 7, **dadurch gekennzeichnet, dass** der erste und zweite Eingang (A_IN, B_IN) mit dem Abgriff (38) verbunden sind.

9. Vorrichtung nach Anspruch 7, **dadurch gekennzeichnet, dass** der erste Eingang (A_IN) mit dem ersten Anschluss (34) des Stellungsgebers (32) und der zweite Eingang (B_IN) mit dem zweiten Anschluss (36) des Stellungsgebers (32) verbunden ist.

10. Vorrichtung nach einem der Ansprüche 1 bis 9, **dadurch gekennzeichnet, dass** die Referenzimpedanz (45) einen ersten Anschluss (44.) aufweist, der mit dem Abgriff (38) verbunden ist.

11. Vorrichtung nach Anspruch 1 bis 10, **dadurch gekennzeichnet, dass** die Referenzimpedanz (45) einen zweiten Anschluss (46) aufweist, der mit einem Ausgang (B_TEST) der Auswerteeinheit (12, 14) verbunden ist.

12. Vorrichtung nach einem der Ansprüche 1 bis 11, **gekennzeichnet durch** eine Vielzahl von Stellungsgebern (P1, P2, P3) mit einer Vielzahl von Abgriffen (38a, 38b, 38c), die miteinander verbunden sind, wobei jeder Stellungsgeber (P1, P2, P3) einen ersten und einen zweiten Anschluss aufweist, der mit der Auswerteeinheit (12, 14) verbunden ist.

13. Vorrichtung nach einem der Ansprüche 2 bis 12, **dadurch gekennzeichnet, dass** der erste und der zweite Auswerteschaltkreis (12, 14) integrierte Schaltkreise, insbesondere programmierbare integrierte Schaltkreise sind, die über den Stellungsgeber (32) miteinander verbunden sind.

14. Sicherheitsschaltvorrichtung zum fehlersicheren Abschalten eines elektrischen Verbrauchers (24, 26), mit zumindest einem Eingang zum Aufnehmen eines Meldesignals (28, 30), das eine Sicherheitsanforderung repräsentiert, mit einer Auswerte- und Steuereinheit (12, 14) zum Auswerten des Meldesignals, mit zumindest einem Schaltelement (16, 18), das dazu ausgebildet ist, einen Strompfad (22) zu dem Verbraucher (24, 26) in Abhängigkeit von der Auswerte- und Steuereinheit (12, 14) fehlersicher zu unterbrechen, und mit einem Stellungsgeber (32) zum Einstellen einer Betriebsgröße der Sicherheitsschaltvorrichtung, **gekennzeichnet durch** eine Vorrichtung nach einem der Ansprüche 1 bis 13 zum fehlersicheren Auswerten des Stellungsgebers (32).

15. Verfahren zum fehlersicheren Auswerten eines Stellungsgebers (32), der zumindest einen ersten und einen zweiten Anschluss (34, 36) besitzt, zwischen denen eine definierte Gesamtimpedanz messbar ist, und der einen verstellbaren Abgriff (38) besitzt, an dem eine erste und eine zweite Teilimpedanz (40, 42) messbar sind, insbesondere zum fehlersicheren Auswerten eines Potentiometers, mit den Schritten:
- Bestimmen einer momentanen Stellposition des Abgriffs (38) mit Hilfe von zumindest einer der Teilimpedanzen (40, 42), und
- Überprüfen des Stellungsgebers (32) mit Hilfe einer Referenzimpedanz (45; 54, 56; 58, 60),
**dadurch gekennzeichnet, dass** eine für die erste Teilimpedanz (40) repräsentative erste Messgröße bestimmt wird, dass eine für die zweite Teilimpedanz (42) repräsentative zweite Messgröße bestimmt wird, und dass die Stellposition des Abgriffs (38) anhand der ersten und der zweiten Messgröße überprüft wird.

## Claims

1. An arrangement for failsafe evaluation of a position encoder (32), which has at least a first terminal and a second terminal (34, 36), between which there is a defined total impedance, and which has an adjustable tap (38), at which a first partial impedance and a second partial impedance (40, 42) can be measured, in particular for failsafe evaluation of a potentiometer, the arrangement comprising an evaluation unit (12, 14) connected to the position encoder (32) in order to determine an instantaneous position of the tap (38) by means of at least one of the partial impedances (40, 42), and comprising a reference impedance (45; 54, 56; 58, 60) for checking the position encoder (32), **characterized in that** the evaluation unit (12, 14) is designed to determine a first measurement value representative of the first partial impedance (40) and a second measurement value representative of the second partial impedance (42).

2. The arrangement of claim 1, **characterized in that** the evaluation unit (12, 14) comprises a first evaluation circuit (12) and a second evaluation circuit (14), each of which being designed to determine at least one of the measurement values.

3. The arrangement of claim 2, **characterized in that** the first evaluation circuit (12) has a first output (A_P1), and the second evaluation circuit (14) has a second output (B_P1), each of which being configured to be connected alternately to a high potential or a low potential.

4. The arrangement of claim 3, **characterized in that** the first output (A_P1) is connected to the first terminal (34) of the position encoder (32), and the second output (B_P1) is connected to the second terminal (36) of the position encoder (32).

5. The arrangement of claim 3, **characterized in that** the first output and the second output (A_P1, B_P1) are connected to the tap (38).

6. The arrangement of one of the claims 3 to 5, **characterized by** at least one switching element designed to isolate the position encoder (32) from the first output or second output (A_P1, B_P1).

7. The arrangement of one of claims 2 to 6, **characterized in that** the first evaluation circuit (12) has a first input (A_IN), and the second evaluation circuit (14) has a second input (B_IN), each of which being connected to the position encoder (32).

8. The arrangement of claim 7, **characterized in that** the first input and the second input (A_IN, B_IN) are connected to the tap (38).

9. The arrangement of claim 7, **characterized in that** the first input (A_IN) is connected to the first terminal (34) of the position encoder (32), and the second input (B_IN) is connected to the second terminal (36) of the position encoder (32).

10. The arrangement of one of claims 1 to 9, **characterized in that** the reference impedance (45) has a first terminal (44) that is connected to the tap (38).

11. The arrangement of one of claims 1 to 10, **characterized in that** the reference impedance (45) has a second terminal (46), which is connected to an output (B_TEST) of the evaluation unit (12, 14).

12. The arrangement of one of claims 1 to 11, **characterized by** a plurality of position encoders (P1, P2, P3) having a plurality of taps (38a, 38b, 38c), which are connected together, with each position encoder (P1, P2, P3) having a first terminal and a second terminal connected to the evaluation unit (12, 14).

13. The arrangement of one of claims 2 to 12, **characterized in that** the first evaluation circuit and the second evaluation circuit (12, 14) are integrated circuits, in particular programmable integrated circuits, which are connected together via the position encoder (32).

14. A safety switching device for failsafe shutdown of an electrical load (24, 26), comprising at least one input for receiving a status signal (28, 30), which represents a safety request, comprising an evaluation and control unit (12, 14) for evaluating the status signal, comprising at least one switching element (16, 18) designed to fail-safely interrupt a current path (22) to the load (24, 26) in response to the evaluation and control unit (12, 14), and comprising a position encoder (32) for setting an operational quantity of the safety switching device, **characterized by** an arrangement according to one of claims 1 to 13 for failsafe evaluation of the position encoder (32).

15. A method for failsafe evaluation of a position encoder (32), which has at least a first terminal and a second terminal (34, 36), between which a defined total impedance can be measured, and which has an adjustable tap (38), at which a first partial impedance and a second partial impedance (40, 42) can be measured, in particular for failsafe evaluation of a potentiometer, comprising the steps:
- determining an instantaneous control position of the tap (38) by means of at least one of the partial impedances (40, 42), and
- checking the position encoder (32) by means of a reference impedance (45; 54, 56; 58, 60),
**characterized in that** a first measurement value representative of the first partial impedance (40) is determined, a second measurement value representative of the second partial impedance (42) is determined, and the first measurement value and second measurement value are used to check the instantaneous position of the tap (38).

## Revendications

1. Dispositif pour l'interprétation sans erreur d'un transmetteur de position (32) qui est pourvu au moins d'une première et d'une deuxième connexion (34, 36) entre lesquelles est appliquée une impédance totale définie, et qui comporte un capteur réglable (38) sur lequel une première et une deuxième impédance partielle (40, 42) sont mesurables, en particulier pour l'interprétation sans erreur d'un potentiomètre, avec une unité d'analyse (12, 14) reliée au transmetteur de position (32) pour déterminer une position de réglage momentanée du capteur (38) au moyen d'au moins une des impédances partielles (40, 42), et avec une impédance de référence (45 ; 54 , 56 ; 58 , 60) pour le contrôle du transmetteur de position (32), **caractérisé en ce que** l'unité d'analyse (12, 14) est prévue pour déterminer une première grandeur de mesure représentative de la première impédance partielle (40) et une deuxième grandeur de mesure représentative de la deuxième impédance partielle (42).

2. Dispositif selon la revendication 1, **caractérisé en ce que** l'unité d'analyse (12, 14) contient un premier circuit d'analyse (12) et un deuxième circuit d'analyse (14) dont chacun est prévu pour déterminer au moins une des grandeurs de mesure.

3. Dispositif selon la revendication 2, **caractérisé en ce que** le premier circuit d'analyse (12) comporte une première sortie (A_P1), et le deuxième circuit d'analyse (14) une deuxième sortie (B_P1), qui peuvent être occupées chacune par un potentiel élevé ou par un faible potentiel, en alternance.

4. Dispositif selon la revendication 3, **caractérisé en ce que** la première sortie (A_P1) est reliée à la première connexion (34) du transmetteur de position (32), et **en ce que** la deuxième sortie (B_P1) est reliée à la deuxième connexion (36) du transmetteur de position (32).

5. Dispositif selon la revendication 3, **caractérisé en ce que** la première et la deuxième sortie (A_P1, B_P1) sont reliées au capteur (38).

6. Dispositif selon l'une des revendications 3 à 5, **caractérisé par** au moins un élément de commutation prévu pour couper le transmetteur de position (32) de la première ou de la deuxième sortie (A_P1, B_P1).

7. Dispositif selon l'une des revendications 2 à 6, **caractérisé en ce que** le premier circuit d'analyse (12) comporte une première entrée (A_IN), et le deuxième circuit d'analyse (14) une deuxième entrée (B_IN), reliées chacune au transmetteur de position (32).

8. Dispositif selon la revendication 7, **caractérisé en ce que** la première et la deuxième entrée (A_IN, B_IN) sont reliées au capteur (38).

9. Dispositif selon la revendication 7, **caractérisé en ce que** la première entrée (A_IN) est reliée à la première connexion (34) du transmetteur (32), et la deuxième entrée (B_IN) à la deuxième connexion (36) du transmetteur (32).

10. Dispositif selon l'une des revendications 1 à 9, **caractérisé en ce que** l'impédance de référence (45) comporte une première connexion (44) reliée au capteur (38).

11. Dispositif selon l'une des revendications 1 à 10, **caractérisé en ce que** l'impédance de référence (45) comporte une deuxième connexion (46) reliée à une sortie (B_TEST) de l'unité d'analyse (12, 14).

12. Dispositif selon l'une des revendications 1 à 11, **caractérisé par** une pluralité de transmetteurs de position (P1, P2, P3) avec une pluralité de capteurs (38a, 38b, 38c) reliés entre eux, chaque transmetteur de position (P1, P2, P3) comportant une première et une deuxième connexion reliée à l'unité d'évaluation (12, 14).

13. Dispositif selon l'une des revendications 2 à 12, **caractérisé en ce que** le premier et le deuxième circuit d'analyse (12, 14) sont des circuits intégrés, en particulier des circuits intégrés programmables reliés l'un à l'autre par le transmetteur de position (32).

14. Dispositif interrupteur de sécurité pour la coupure sans erreur d'un récepteur électrique (24, 26), avec au moins une entrée pour la réception d'un signal d'état (28, 30) représentant une demande de sécurité, avec une unité de commande et d'analyse (12, 14) pour l'interprétation du signal d'état, avec au moins un élément de commutation (16, 18) prévu pour interrompre sans erreur un chemin de courant (22) vers le récepteur (24, 26) en fonction de l'unité de commande et d'analyse (12, 14), et avec un transmetteur de position (32) pour le réglage d'une grandeur de service du dispositif interrupteur de sécurité, **caractérisé par** un dispositif selon l'une des revendications 1 à 13 pour l'interprétation sans erreur du transmetteur de position (32).

15. Procédé pour l'interprétation sans erreur d'un transmetteur de position (32) qui est pourvu au moins d'une première et d'une deuxième connexion (34, 36) entre lesquelles une impédance totale définie est mesurable, et qui comporte un capteur réglable (38) sur lequel une première et une deuxième impédance partielle (40, 42) sont mesurables, en particulier pour l'interprétation sans erreur d'un potentiomètre, comportant les étapes suivantes :
- détermination d'une position de réglage momentanée du capteur (38) au moyen d'au moins une des impédances partielles (40, 42), et
- contrôle du transmetteur de position (32) au moyen d'une impédance de référence (45 ; 54 , 56 ; 58 , 60),
**caractérisé en ce qu'**une première grandeur de mesure représentative de la première impédance partielle (40) est déterminée, **en ce qu'**une deuxième grandeur de mesure représentative de la deuxième impédance partielle (42) est déterminée, et **en ce que** la position de réglage du capteur (38) est contrôlée sur la base de la première et de la deuxième grandeur de mesure.
